# EUROPEAN PATENT SPECIFICATION

(11) **EP 1 144 933 B1**
(45) Date of publication and mention of the grant of the patent: **10.03.2004**
(21) Application number: 99965662.2
(22) Date of filing: 17.12.1999
(51) Int. Cl.: F28D 20/02, H01L 23/427, H05K 7/20

(54) **A DEVICE FOR TEMPERATURE CONTROL**
VORRICHTUNG ZUR REGULIERUNG DER TEMPERATUR
DISPOSITIF DE REGULATION DE LA TEMPERATURE

(30) Priority: 22.12.1998 SE 9804510
(43) Date of publication of application: 17.10.2001
(73) Proprietor: Telefonaktiebolaget L M Ericsson (Publ), 126 25 Stockholm (SE)
(72) Inventor: CELEGIN, Mario, S-435 42 Mölnlycke (SE); FALK, Hans, S-431 37 Mölndal (SE); MELIN, Peter, S-437 42 Lindome (SE)
(74) Representative: Sjöberg, Mats Hakan
(86) International application number: PCT/SE1999/002413
(87) International publication number: WO 2000/037873

(56) References cited:
- WO-A1-96/28846
- US-A- 3 215 194
- US-A- 3 328 642
- US-A- 4 057 101
- US-A- 5 007 478
- US-A- 5 220 954
- US-A- 5 455 458
- US-A- 5 831 831

## Description

### Technical field

The present invention relates to the field of devices for temperature control; in particular, the invention relates to the areas of this field which concern controlling the temperature of a heat generating object when the temperature of a surrounding region varies within a predetermined interval.

### State of the art

In electric circuits a non-negligible heat generation often takes place. If the generated heat is not taken care of in a suitable way, the circuits run the risk of being overheated. To control the temperature of electric circuits, it is therefore common to arrange different forms of cooling systems in connection with the circuits.

Some of these cooling systems are active in the sense that extra power must be supplied for the cooling to be able to take place. Fans are an example of active cooling systems, also cooling systems, which use the same physical principles as refrigerators and freezers, are active. A disadvantage of active cooling systems is of course that they require a supply of power in order to work. If the power supply would for some reason be interrupted, the circuits run the risk of being overheated. Active cooling systems are often relatively complicated and therefore require a larger amount of maintenance. These features of the active cooling systems result in that they are not regarded suitable for circuits in outdoor equipment, such as radio base stations in mobile telephone systems.

Other such cooling systems are passive, and no extra power needs to be supplied for these to work. The passive cooling systems are often constructed to conduct in an efficient way the generated heat in the circuits to the surrounding air. Different physical processes are hereby used to achieve this, such as natural convection, heat radiation and evaporation. To achieve an effective thermal connection to the surrounding air, the passive cooling systems often comprise heat exchangers with heat sinks, e.g. in the form of cooling flanges.

An example of a passive cooling system is given in US Patent 5 529 115. In this patent document, devices for cooling electric circuits are shown. A chamber is partly filled with a liquid which is vaporized by the heat which develops in the electric circuits. The vaporized liquid is condensed against the ceiling of the chamber, and the condensation drops fall back into the liquid. Special means are provided for guiding the condensation drops back in a suitable way so that stagnation is avoided.

Another example of a passive cooling system is given by US Patent 5 390 077. In this patent document, a device for cooling electric circuits is shown. The device comprises a container with an upper part (cold plate) and a lower part. The container is filled with liquid. The upper part is thermally connected to a heat exchanger with a number of cooling flanges. The electric circuits are arranged on the lower part and are completely submerged in the liquid, to maximize the heat transfer. The dimensions of the container are such that a Raleigh number of at least 1700 is achieved, whereby an effective heat transport between the upper part and the lower part is achieved because of a well-established natural convection in the container.

Patent US-5 220 954 shows a heat exchanger for a phase change material comprising a container holding the phase change material and a separate passageway system surrounding the container for receiving a heat exchange fluid. The phase-change material container serves as a thermal reservoir, i.e. such as to store latent heat of fusion during a heating cycle and to release latent heat of fusion during a cooling cycle.

Patent US-5 455 458 shows a semiconductor wafer mounted on a substrate, which on one side is surrounded by a housing, and on the other side is thermally connected to a cold plate for proving cooling of the wafer. The housing is filled with a phase-change material, such as paraffin, for absorbing and releasing energy relating to operational cycles.

Patent US-4 057 101, on which the preamble of claim 1 is based, shows electronic equipment mounted on one wall of a sealed container of which opposing wall a radiator is mounted for transferring heat to the surroundings. The container constitutes a heat sink device and comprises an aluminium honeycomb structure, directed to provide good thermal conductivity between the opposing walls of the container. A phase-change material surrounds the honeycomb structure and serves as a thermal reservoir for heat fluctuations.

A large volume of modern electronics are not specified for temperatures below 0°C.
However, electric circuits in outdoor equipment must work even if the temperature of the surrounding air falls towards -35°C. A disadvantage of the passive cooling systems is in this case that these cooling systems cool the electric circuits very well, also at low air temperatures, whereby the temperature in the electric circuits runs the risk of becoming lower than 0°C. One way to avoid this disadvantage is to install heaters which heat the electronics at low air temperatures, so that the temperature in the electronics will not fall below 0°C. However, this solution has several disadvantages, such as: high costs (heater, control equipment, mechanical equipment, wiring etc.), space requirements (heater and associated equipment) and high electric power consumption (it is not unusual that the heater consumes more electric power than is normally consumed by the equipment itself).

### Description of the invention

The present invention tackles the problem of achieving a device for controlling the temperature of a heat generating object, e.g. electronics, so that the temperature of the object will not exceed a predetermined maximum value or fall below a predetermined minimum value when the temperature of a surrounding region varies within a predetermined interval.

In short, the problem stated above is solved according to the following. The device according to the invention comprises a heat exchanger, which is arranged for emitting heat to the surrounding region. The device further comprises a container, which is arranged to contain a medium with temperature-dependent properties. The container is thermally connected to the object as well as to the heat exchanger. When the temperature of the surrounding region exceeds a first value, the medium has a low viscosity, and heat generated by the object is transported in the container in a relatively effective way, from the object to the heat exchanger by natural convection in the medium. Since the heat transport by natural convection is relatively effective, the temperature of the object is kept low and thus does not exceed the maximum value. The medium is chosen to have such temperature dependent properties that the natural convection in the medium mainly is prevented when the temper-ature of the surrounding region falls below a second value. The heat generated by the object is then transported in the container from the object to the heat exchanger mainly by thermal conduction in the medium. However, the heat transport by thermal conduction is considerably less effective than that by natural convection, for which reason the temperature of the object will not fall below the minimum value. Thus, the container has a heat transferability which varies relatively strongly in dependence upon the temperature of the surrounding region. At higher temperatures of the surrounding region, the heat transferability is good, while the heat transferability at lower temperatures of the surrounding region is relatively poor, whereby the container isolates the object from the heat exchanger.

Thus, the purpose of the invention is to control the temperature of the object when the temperature of the surrounding region varies in a predetermined interval, and the invention comprises a device for achieving this.

A main advantage of the invention, apart from solving the problem stated above, is that the temperature control of the object is completely passive.

The invention will now be described more closely with the aid of preferred embodiments and with reference to the attached drawings.

### Description of the figures

Figure 1 shows, in a sectional view, as an example according to the invention, a device for controlling the temperature of electronics.
Figure 2 shows, in a diagram, a curve showing how a temperature difference (the vertical axis) between the temperature of the electronics and the temperature of a surrounding region varies in dependence upon the temperature of the surrounding region (the horizontal axis).

### Preferred embodiments

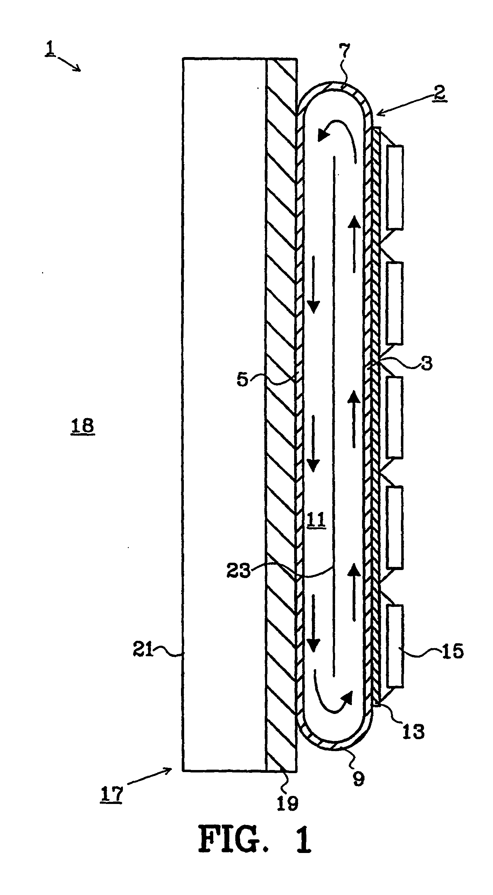

In Fig. 1, a device 1 for controlling the temperature of electronics is shown in a sectional view, as an example according to the present invention. Here the expression 'electronics' comprises all forms of electric equipment, such as separate electric components, electric circuits, radio equipment, microwave equipment, and so on. The device 1 in Fig. 1 can, of course, also be used to control the temperature of other objects than electronics.

The device 1 in Fig. 1 comprises a container 2 with a first mainly flat wall 3 and a second mainly flat wall 5, which is opposite to the first wall 3. In the example shown in Fig. 1 the first and the second walls 3 and 5 are arranged mainly vertically. The container 2 further comprises an upper part 7 and a lower part 9. The container 2 additionally comprises further walls (not shown), which together with the first and the second walls 3 and 5 and the upper and lower parts 7 and 9 enclose a space containing a medium 11. In the example shown in Fig. 1, the medium 11 is a liquid with a temperature-dependent viscosity. Electronics in the form of a printed circuit board 13 with electric circuits 15 is arranged on the outside of the first wall 3 so that the electric circuits 15 have good thermal connection to the first wall 3. The device 1 comprises a heat exchanger 17 with a base plate 19 on which heat sinks in the form of cooling flanges 21 are arranged. The heat exchanger 17 is arranged with the base plate 19 against the outside of the second wall 5 so that the heat exchanger 17 has good thermal contact with the second wall 5. The heat exchanger 17 is arranged for emitting heat to a surrounding region 18 with a temperature Tₛ. The surrounding region 18 in Fig. 1 constitutes a surrounding atmosphere, but is alternatively some other form of heat absorber or something else to which heat can be emitted from the heat exchanger 17. The invention is not limited to the particular design of heat exchanger 17 shown in Fig. 1, rather the heat exchanger 17 is alternatively some other means by which heat can be emitted to the surrounding region 18. For example, the heat exchanger 17 instead constitutes a wall, the surface and thermal conductivity of which being sufficient for effectively emitting heat to the surrounding region 18.

The device 1 in Fig. 1 is arranged to control a temperature T_{c} of the electric circuits 15 when the temperature Tₛ of the surrounding region 18 varies within a predetermined interval [Tₛ₁,Tₛ₂] between a lower and an upper temperature Tₛ₁ and Tₛ₂. The temperature T_{c} of the electric circuits 15 is in this case controlled so that it does not exceed a predetermined maximum value T_{cmax} and also so that it does not fall below a predetermined minimum value T_{cmin}. In the example shown in Fig. 1, Tₛ₁ = -33°C, Tₛ₂ = 55°C, T_{cmin} = 0°C and T_{cmax} = 75°C, which are values often stated in technical specifications, which is well known for a person skilled in the art.

The invention is, of course, not limited to the temperature values given above, rather the person skilled in the art has the possibility of choosing these, according to the circumstances, in another way and to adapt the device 1 thereafter. For example, Tₛ₁ is chosen between -40°C and -25°C, T_{cmin} between -10°C and 20°C, Tₛ₂ between 40°C and 55°C, and T_{cmax} between 60°C and 75°C.

In Fig. 1, the device 1 is shown when the temperature Tₛ of the surrounding region 18 exceeds a predetermined first value T1, which is less than Tₛ₂. Then the medium 11 in the container 2 has a low viscosity (is very liquid). Heat generated by the electric circuits 15 heats the first wall 3, which in turn heats the medium 11 in contact with the first wall 3. The heating of the medium 11 at the first wall 3 causes an upwardly directed natural convection flow indicated by the upwardly directed arrows in Fig. 1. The upwardly directed natural convection flow turns at the upper part 7 of the container 2, whereby heated medium I 1 approaches at the second wall 5. Thereby the heated medium emits heat, via the second wall 5, to the heat exchanger 17. The heat exchanger 17 in turn emits the heat to the surrounding region 18. The heated medium 11 is cooled at the second wall 5, which causes a downwardly direction natural convection flow, as indicated by downwardly directed arrows in Fig. 1. The downwardly directed natural convection flow turns at the lower part 9 of the container 2, whereby the cooled medium 11 approaches at the first wall 3. Thus, in the container 2, there exists a circulating natural convection flow which in a relatively effective way transports the heat generated by the electric circuits 15 through the container 2 to the heat exchanger 17, where the heat is emitted to the surrounding region 18. A plate 23 is arranged in the container 2 between the first and the second wall 3 and 5. However, the plate 23 does not reach all the way up to the upper part 7 of the container 2 and also does not reach all the way down to the lower part 9 of the container 2. The plate 23 keeps the upwardly directed natural convection flow at the first wall 3 separated from the downwardly directed natural convection flow at the second wall 5, which reinforces the circulating flow in the container 2.

The upper part 7 and the lower part 9 are arranged to thermally isolate the first and the second walls 3 and 5 from each other. For example, the upper part 7 and the lower part 9 are thin or made of a thermally isolated material, or are both thin and made of a thermally isolated material.

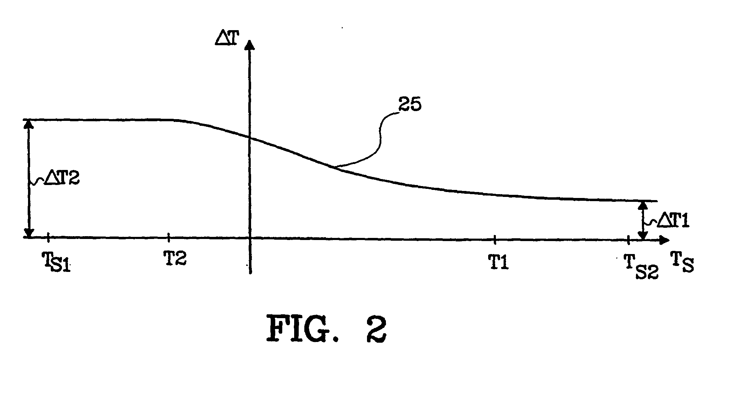

Fig. 2 shows, in a diagram, a curve 25, which schematically describes how a temperature difference ΔT (the vertical axis) between the temperature T_{c} of the electric circuits 15 and the temperature Tₛ of the surrounding region 18 varies in dependence of the temperature Tₛ of the surrounding region 18 (the horizontal axis). When the temperature Tₛ of the surrounding region 18 exceeds the first value T1, the medium 11 is, as mentioned, very fluid and the heat generated by the electric circuits 15 is transported mainly by natural convection in the container 2 to the heat exchanger 17. The temperature difference ΔT is therefore relatively small when the temperature Tₛ of the surrounding region 18 exceeds the first value T1. Additionally, when the temperature Tₛ of the surrounding region 18 exceeds the first value T1, the temperature difference ΔT is mainly constant and thus corresponds approximately to a fixed first difference value ΔT1. The first difference value ΔT1 is dependent upon the properties of the medium 11, such as viscosity, density, thermal conductivity and specific heat capacity, the shape of the container 2, primarily the areas of the first and the second walls 3 and 5 and the distance between the first and the second walls 3 and 5, as well as the dimensioning of the heat exchanger 17. In this case, the container 2 and the heat exchanger 17 are designed with consideration taken to the properties of the medium 11 so that for the first difference value ΔT1 it is true that ΔT1 < T_{cmax} - Tₛ₂, for which reason the temperature T_{c} of the electric circuits 15 does not exceed the maximum value T_{cmax}.

In order for the temperature T_{c} of the electric circuits 15 not to fall below the minimum value T_{cmin}, the medium 11 is chosen so that its temperature-dependent viscosity is such that the viscosity is sufficiently high to mainly prevent the natural convection flow in the container 2, when the temperature Tₛ of the surrounding region 18 falls below a predetermined second value T2 (which is less than T1 and higher than Tₛ₁). In this connection, the expression 'is mainly prevented' means that the natural convection is prevented completely or to such a degree that the heat transport by natural convection in the container 2 is negligible. Thus, when the temperature Tₛ of the surrounding region 18 falls below the second value T2, the heat generated by the electric circuits 15 is transported mainly by means of thermal conduction through the container 2 to the heat exchanger 17. However, the heat transport by thermal conduction is considerably less effective than the heat transport by natural convection. Thereby the container 2 causes merely an isolating effect between the electric circuits 15 and the heat exchanger 17, which causes the temperature difference ΔT to be considerably larger than what is the case when the natural convection is well established. When the temperature Tₛ of the surrounding region 18 falls below the second value T2, the temperature difference ΔT is mainly constant and thus corresponds approximately to a fixed second difference value ΔT2. The second difference value ΔT2 depends upon the thermal conductivity of the medium 11, the shape of the container 2, primarily the areas of the first and the second walls 3 and 5 and the distance between the first and the second walls 3 and 5, as well as the dimensioning of the heat exchanger 17. The container 2 and the heat exchanger 17 are designed with consideration taken to the thermal conductivity of the medium 11 so that for the second difference value ΔT2 it is true that ΔT2 > T_{cmin} - Tₛ₁, the reason for which the temperature T_{c} of the electric circuits does not fall below the minimum value T_{cmin}.

The second value T2 is adapted so that the natural convection is mainly prevented in sufficient advance when the temperature Tₛ of the surrounding region 18 falls, for the temperature T_{c} of the electric circuits 15 not to fall below the minimum value T_{cmin}, but for other aspects the choice of the second value T2 is not critical. In a corresponding way the first value T1 is adapted so that a well established natural convection flow is obtained in the container 2 sufficiently in advance, when the temperature Tₛ of the surrounding region 18 increases, for the temperature of the electrical circuits T_{c} not to exceed the maximum value T_{cmax}, but apart from that also the choice of the second value T2 is not critical. Fig. 2 shows that, when the temperature Tₛ of the surrounding region 18 varies in the interval between the second and the first values T2 and T1, there is a gradual transition from heat transport mainly by thermal conductivity in the container 2 to heat transport mainly by natural convection in the container 2. This is, of course, because the medium 11 gradually obtains a lower viscosity when the temperature Tₛ of the surrounding region 18 increases.

The medium 11 is in the example shown in Figs. 1 and 2, a fluid with temperature-dependent viscosity. The fluid is, for example, a suitably chosen oil. Another alternative is that the fluid is a mixture of water and glycol. As a suggestion, the percentage by weight of glycol comprised in the mixture is 5 to 60, which gives a viscosity which varies relatively strongly with the temperature. Especially, the percentage by weight of glycol comprised in the mixture is approximately 60.

Another alternative is that the medium 11 is a substance which is fluid and has low viscosity when the temperature of the surrounding region 18 exceeds the first value T1, whereby the heat generated by the electric circuits 15 is transported mainly by natural convection through the container 2 to the heat exchanger 17, in a manner corresponding to that in Fig. 1. However, the temperature-dependent properties of the substance are adapted so that the natural convection in the container 2 is mainly prevented when the temperature Tₛ of the surrounding region 18 falls below the second value T2 by the substance solidifying. For example, the substance consists of different forms of salts with melting points suitable for the circumstances, such as sodium acetate trihydrate (C₂H₃NaO₂H₆O₃) or glauberite (Na₂Ca(SO₄)₂). Another alternative is that the substance is paraffin or similar.

Yet another alternative is that the medium 11 comprises a liquid which has low viscosity. In the liquid with low viscosity, there is an additive which, in dependence upon the temperature Tₛ of the surrounding region 18 forms a precipitate in the liquid, whereby the natural convection in the container 2 is mainly prevented by the precipitate when the temperature Tₛ of the surrounding region 18 falls below the second value T2.

In the example shown in Fig. 1, the container 2 is oriented so that the first and second walls 3 and 5 are mainly vertical. However, the invention is not limited to only this orientation of the container 2, rather, alternatively, the container 2 can be oriented in another way. For example, the container 2 is oriented so that the first and the second walls 3 and 5 are mainly horizontal, whereby the plate 23 is suitably omitted.

Neither is the invention limited to only the shape of the container 2 shown in Fig. I, but, alternatively, the container 2 has some other shape. For example, the first wall 3 is given a shape in which its contour is adapted relative to the shape of the object the temperature of which is to be controlled, whereby the device 1 takes up less room and the thermal connection between the object and the container 2 is enhanced.

## Claims

1. Device (1) comprising: a heat generating object (15), a heat exchanger (17) for emitting heat to a surrounding region (18); and a container (2) which contains a medium (11), and which is thermally connected to the object (15) as well as the to the heat exchanger (17), the device being adapted for controlling the temperature of the heat-generating object (15), whereby the medium (11) in the container (2) has temperature-dependent properties, the medium has low viscosity when the temperature of the medium exceeds a predetermined value, the container (2) and the heat exchanger (17) being arranged so that a heat effect generated by the object (15) is transported, by natural convection in the medium (11), from the object (15) to the heat exchanger (17); wherein
the temperature-dependent properties of the medium (11) are adapted so that the natural convection in the medium (11) is mainly prevented when the temperature of the medium falls below another predetermined value, **characterized in that**
the device is being adapted for controlling the temperature of the heat-generating object (15) when the temperature of a surrounding region (18) varies within a restricted interval, wherein the temperature-dependent properties of the medium (11) are adapted so that the medium has low viscosity when the temperature of the surrounding region (18) exceeds a predetermined first value, and so that the natural convection in the medium (11) is mainly prevented when the temperature of the surrounding region (18) falls below a predetermined second value, which is less than the first value, the container (2) and the heat exchanger (17) being so arranged
- that a heat effect generated by the object (15) is transported, by natural convection in the medium (11), from the object (15) to the heat exchanger (17), without a temperature of the object (15) exceeding a predetermined maximum value, and
- that the heat effect is transported mainly by thermal conduction in the medium (11), from the object (15) to the heat exchanger (17), without the temperature of the object (15) falling below a predetermined minimum value.

2. Device according to Claim 1, **characterized in that** the temperature dependent properties of the medium (11) are such that the natural convection in the medium is mainly prevented when the temperature of the surrounding region (18) falls below the second value due to solidification of the medium (11).

3. Device according to Claim 2, **characterized in that** the medium (11) contains paraffin.

4. Device according to Claim 2, **characterized in that** the medium (11) contains a salt with a suitable melting point.

5. Device according to Claim 4, **characterized in that** the salt is sodium acetate trihydrate.

6. Device according to Claim 4, **characterized in that** the salt is glauberite.

7. Device according to Claim 1, **characterized in that** the medium (11) is a liquid with temperature-dependent viscosity, whereby the natural convection in the medium (11) is mainly prevented when the temperature of the surrounding region (18) falls below the second value because the medium is then viscous.

8. Device according to Claim 7, **characterized in that** the medium (11) is an oil.

9. Device according to Claim 7, **characterized in that** the medium (11) is a mixture comprising water and glycol.

10. Device according to Claim 9, **characterized in that** the mixture comprises between 5 and 60 percent by weight of glycol.

11. Device according to Claim 1, **characterized in that** the medium (11) comprises a liquid with an additive which, depending upon the temperature of the surrounding region, forms a precipitate in the liquid, whereby the natural convection in the medium is mainly prevented by the precipitate when the temperature of the surrounding region (18) falls below the second value.

12. Device according to anyone of Claims 1 - 11, **characterized in that** the container (2) comprises a first wall (3), which is arranged in good thermal contact with the object (15); and that the container (2) comprises a second wall (5), which is mainly opposite to the first wall (3), and is arranged in good thermal contact with the heat exchanger.

13. Device according to Claim 12, **characterized in that** the first and the second walls (3,5) are arranged mainly vertically.

14. Device according to Claim 13, **characterized in that** the container (2) comprises means (23) for separating a natural convection flow along the first wall (3) from a natural convection flow along the second wall (5).

15. Device according to Claim 14, **characterized in that** the means for separating the natural convection flows is a plate (23) which is arranged between the first and the second walls (3,5).

16. Device according to Claim 12, **characterized in that** the first and the second walls are arranged mainly horizontally.

17. Device according to anyone of Claims 12 - 16, **characterized in that** the container (2) is arranged so that the first and the second walls (3,5) are thermally isolated from each other.

18. Device according to anyone of Claims 1 - 17, **characterized in that** the object (15) comprises electronics (15).

## Patentansprüche

1. Vorrichtung (1), umfassend: ein wärmegenerierendes Objekt (15), einen Wärmetauscher (17) zum Emittieren von Wärme in eine Umgebungsregion (18); und einen Container (2), der ein Medium (11) enthält, und der mit dem Objekt (15) ebenso wie mit dem Wärmetauscher (17) thermisch verbunden ist, wobei die Vorrichtung zum Steuern der Temperatur des wärmegenerierenden Objekts (15) angepasst ist, wodurch das Medium (11) in dem Container (2) temperaturabhängige Eigenschaften aufweist, das Medium niedrige Viskosität hat, wenn die Temperatur des Mediums einen vorbestimmten Wert überschreitet, wobei der Container (2) und der Wärmetauscher (17) angeordnet sind, sodass ein Wärmeeffekt, der durch das Objekt (15) generiert wird, durch natürliche Konvektion in dem Medium (11) von dem Objekt (15) zu dem Wärmetauscher (17) transportiert wird; worin die temperaturabhängigen Eigenschaften des Mediums (11) angepasst sind, sodass die natürliche Konvektion in dem Medium (11) hauptsächlich verhindert wird, wenn die Temperatur des Mediums unter einen anderen vorbestimmten Wert fällt,
**gekennzeichnet dadurch, dass**
die Vorrichtung für einer Steuerung der Temperatur des wärmegenerierenden Objekts (15) angepasst ist, wenn die Temperatur einer Umgebungsregion (18) innerhalb eines begrenzten Intervalls variiert, worin die temperaturabhängigen Eigenschaften des Mediums (11) angepasst sind, sodass das Medium niedrige Viskosität aufweist, wenn die Temperatur der Umgebungsregion (18) einen ersten vorbestimmten Wert überschreitet, und sodass die natürliche Konvektion in dem Medium (11) hauptsächlich verhindert wird, wenn die Temperatur der Umgebungsregion (18) unter einen vorbestimmten zweiten Wert fällt, der kleiner als der erste Wert ist,
wobei der Container (2) und der Wärmetauscher (17) derart angeordnet sind,
- dass ein Wärmeeffekt, der durch das Objekt (15) generiert wird, durch natürliche Konvektion in dem Medium (11) von dem Objekt (15) zu dem Wärmetauscher (17) transportiert wird, ohne dass eine Temperatur des Objekts (15) einen vorbestimmten Maximalwert überschreitet, und
- dass der Wärmeeffekt hauptsächlich durch thermische Leitung in dem Medium (11) von dem Objekt (15) zu dem Wärmetauscher (17) transportiert wird, ohne dass die Temperatur des Objekts (15) unter einen vorbestimmten Minimalwert fällt.

2. Vorrichtung nach Anspruch 1, **gekennzeichnet dadurch, dass** die temperaturabhängigen Eigenschaften des Mediums (11) derart sind, dass die natürliche Konvektion in dem Medium wegen einer Erstarrung des Mediums (11) hauptsächlich verhindert wird, wenn die Temperatur der Umgebungsregion (18) unter den zweiten Wert fällt.

3. Vorrichtung nach Anspruch 2, **gekennzeichnet dadurch, dass** das Medium (11) Paraffin enthält.

4. Vorrichtung nach Anspruch 2, **gekennzeichnet dadurch, dass** das Medium (11) ein Salz mit einem geeigneten Schmelzpunkt enthält.

5. Vorrichtung nach Anspruch 4, **gekennzeichnet dadurch, dass** das Salz Natriumazetattrihydrat ist.

6. Vorrichtung nach Anspruch 4, **gekennzeichnet dadurch, dass** das Salz Glauberit ist.

7. Vorrichtung nach Anspruch 1, **gekennzeichnet dadurch, dass** das Medium (11) eine Flüssigkeit mit temperaturabhängiger Viskosität ist, wodurch die natürliche Konvektion in dem Medium (11) hauptsächlich verhindert wird, wenn die Temperatur der Umgebungsregion (18) unter den zweiten Wert fällt, da das Medium dann viskos ist.

8. Vorrichtung nach Anspruch 7, **gekennzeichnet dadurch, dass** das Medium (11) ein Öl ist.

9. Vorrichtung nach Anspruch 7, **gekennzeichnet dadurch, dass** das Medium (11) eine Mischung ist, die Wasser und Glykol umfasst.

10. Vorrichtung nach Anspruch 9, **gekennzeichnet dadurch, dass** die Mischung zwischen 5 und 60 Massenanteil in Prozent. von Glykol umfasst.

11. Vorrichtung nach Anspruch 1, **gekennzeichnet dadurch, dass** das Medium (11) eine Flüssigkeit mit einem Zuschlagstoff umfasst, der abhängig von der Temperatur der Umgebungsregion eine Ablagerung in der Flüssigkeit bildet, wodurch die natürliche Konvektion in dem Medium hauptsächlich durch die Ablagerung verhindert wird, wenn die Temperatur der Umgebungsregion (18) unter den zweiten Wert fällt.

12. Vorrichtung nach einem beliebigen der Ansprüche 1-11, **gekennzeichnet dadurch, dass** der Container (2) eine erste Wand (3) umfasst, die in gutem thermischen Kontakt mit dem Objekt (15) angeordnet ist; und
dass der Container (2) eine zweite Wand (5) umfasst, die hauptsächlich der ersten Wand (3) entgegenliegt und in gutem thermischen Kontakt mit dem Wärmetauscher angeordnet ist.

13. Vorrichtung nach Anspruch 12, **gekennzeichnet dadurch, dass** die ersten und zweiten Wände (3, 5) hauptsächlich vertikal angeordnet sind.

14. Vorrichtung nach Anspruch 13, **gekennzeichnet dadurch, dass** der Container (2) Mittel (23) zum Trennen eines natürlichen Konvektionsflusses entlang der ersten wand (3) von einem natürlichen Konvektionsfluss entlang der zweiten Wand (5) umfasst.

15. Vorrichtung nach Anspruch 14, **gekennzeichnet dadurch, dass** das Mittel zum Trennen der natürlichen Konvektionsflüsse eine Platte (23) ist, die zwischen den ersten und den zweiten Wänden (3, 5) angeordnet ist.

16. Vorrichtung nach Anspruch 12, **gekennzeichnet dadurch, dass** die ersten und die zweiten Wände hauptsächlich horizontal angeordnet sind.

17. Vorrichtung nach einem beliebigen der Ansprüche 12-16, **gekennzeichnet dadurch, dass** der Container (2) angeordnet ist, sodass die ersten und die zweiten wände (3, 5) thermisch voneinander isoliert sind.

18. Vorrichtung nach einem beliebigen der Ansprüche 1-17, **gekennzeichnet dadurch, dass** das Objekt (15) Elektronik (15) umfasst.

## Revendications

1. Dispositif (1) comprenant : un objet générant de la chaleur (15), un échangeur de chaleur (17) pour émettre de la chaleur vers une région environnante (18); et une enceinte (2) qui contient un milieu (11), et qui est en couplage thermique avec l'objet (15) ainsi qu'avec l'échangeur de chaleur (17), le dispositif étant adapté pour commander la température de l'objet générant de la chaleur (15), le milieu (11) dans l'enceinte (2) ayant des propriétés qui dépendent de la température, le milieu ayant une faible viscosité lorsque la température du milieu dépasse une valeur prédéterminée, l'enceinte (2) et l'échangeur de chaleur (17) étant adaptés de façon qu'un effet thermique, généré par l'objet (15), soit transporté, par convection naturelle dans le milieu (11), de l'objet (15) à l'échangeur de chaleur (17); dans lequel les propriétés du milieu (11) dépendant de la température sont adaptées de façon que la convection naturelle dans le milieu (11) soit empêchée en majeure partie lorsque la température du milieu tombe au-dessous d'une autre valeur prédéterminée, **caractérisé en ce que**
le dispositif est adapté pour commander la température de l'objet (15) générant de la chaleur lorsque la température d'une région environnante (18) varie à l'intérieur d'un intervalle restreint, les propriétés du milieu (11) dépendant de la température étant adaptées de façon que le milieu ait une faible viscosité lorsque la température de la région environnante (18) dépasse une première valeur prédéterminée, et de façon que la convection naturelle dans le milieu (11) soit empêchée en majeure partie lorsque la température de la région environnante (18) tombe au-dessous d'une seconde valeur prédéterminée, qui est inférieure à la première valeur,
l'enceinte (2) et l'échangeur de chaleur (17) étant adaptés de façon
- qu'un effet thermique généré par l'objet (15) soit transporté, par convection naturelle dans le milieu (11), de l'objet (15) à l'échangeur de chaleur (17), sans qu'une température de l'objet (15) dépasse une valeur maximale prédéterminée, et
- que l'effet thermique soit transporté principalement par conduction thermique dans le milieu (11), de l'objet (15) à l'échangeur de chaleur (17), sans que la température de l'objet (15) tombe au-dessous d'une valeur minimale prédéterminée.

2. Dispositif selon la revendication 1, **caractérisé en ce que** les propriétés du milieu (11) dépendant de la température sont telles que la convection naturelle dans le milieu est empêchée en majeure partie lorsque la température de la région environnante (18) tombe au-dessous de la seconde valeur, à cause de la solidification du milieu (11).

3. Dispositif selon la revendication 2, **caractérisé en ce que** le milieu (11) contient de la paraffine.

4. Dispositif selon la revendication 2, **caractérisé en ce que** le milieu (11) contient un sel avec un point de fusion approprié.

5. Dispositif selon la revendication 4, **caractérisé en ce que** le sel est du trihydrate d'acétate de sodium.

6. Dispositif selon la revendication 4, **caractérisé en ce que** le sel est de la glaubérite.

7. Dispositif selon la revendication 1, **caractérisé en ce que** le milieu (11) est un liquide avec une viscosité dépendant de la température, grâce à quoi la convection naturelle dans le milieu (11) est empêchée en majeure partie lorsque la température de la région environnante (18) tombe au-dessous de la seconde valeur, du fait que le milieu est alors visqueux.

8. Dispositif selon la revendication 7, **caractérisé en ce que** le milieu (11) est une huile.

9. Dispositif selon la revendication 7, **caractérisé en ce que** le milieu (11) est un mélange comprenant de l'eau et du glycol.

10. Dispositif selon la revendication 9, **caractérisé en ce que** le mélange comprend entre 50 et 60% en poids de glycol.

11. Dispositif selon la revendication 1, **caractérisé en ce que** le milieu (11) comprend un liquide avec un additif qui, en fonction de la température de la région environnante, forme un précipité dans le liquide, grâce à quoi la convection naturelle dans le milieu est empêchée en majeure partie par le précipité lorsque la température de la région environnante (18) tombe au-dessous de la seconde valeur.

12. Dispositif selon l'une quelconque des revendications 1-11, **caractérisé en ce que** l'enceinte (2) comprend une première paroi (3), qui est disposée en bon contact thermique avec l'objet (15); et
**en ce que** l'enceinte (2) comprend une seconde paroi (5), qui est essentiellement opposée à la première paroi (3), et qui est disposée en bon contact thermique avec l'échangeur de chaleur.

13. Dispositif selon la revendication 12, **caractérisé en ce que** les première et seconde parois (3, 5) sont disposées essentiellement verticalement.

14. Dispositif selon la revendication 13, **caractérisé en ce que** l'enceinte (2) comprend un moyen (23) pour séparer un écoulement de convection naturelle le long de la première paroi (3) d'un écoulement de convection naturelle le long de la seconde paroi (5).

15. Dispositif selon la revendication 14, **caractérisé en ce que** le moyen pour séparer les écoulements de convection naturelle est une plaque (23) qui est disposée entre les première et seconde parois (3, 5).

16. Dispositif selon la revendication 12, **caractérisé en ce que** les première et seconde parois sont disposées essentiellement horizontalement.

17. Dispositif selon l'une quelconque des revendications 12-16, **caractérisé en ce que** l'enceinte (2) est adaptée de façon que les première et seconde parois (3, 5) soient isolées thermiquement l'une de l'autre.

18. Dispositif selon l'une quelconque des revendications 1-17, **caractérisé en ce que** l'objet (15) comprend des circuits électroniques (15).
